# EUROPEAN PATENT SPECIFICATION

(11) **EP 4 432 798 B1**
(45) Date of publication and mention of the grant of the patent: **23.04.2025**
(21) Application number: 23305366.9
(22) Date of filing: 16.03.2023
(51) Int. Cl.: H05K 7/20

(54) **HYBRID COOLING ARRANGEMENT FOR AUTONOMOUS AND IMMERSION COOLED RACKS**
HYBRIDE KÜHLANORDNUNG FÜR AUTONOME UND TAUCHGEKÜHLTE GESTELLE
AGENCEMENT DE REFROIDISSEMENT HYBRIDE POUR ÉTAGÈRES REFROIDIES PAR IMMERSION ET AUTONOMES

(43) Date of publication of application: 18.09.2024
(73) Proprietor: OVH, 59100 Roubaix (FR)
(72) Inventor: HNAYNO, Mohamad, 59100 Roubaix (FR); CHEHADE, Ali, 59283 Moncheaux (FR)
(74) Representative: BCF Global

(56) References cited:
- WO-A1-2022/162174
- WO-A1-2022/208403
- US-A1- 2018 098 464
- US-A1- 2022 100 241
- US-A1- 2022 201 896

## Description

### FIELD OF TECHNOLOGY

The present technology generally relates to cooling techniques of electronic equipment rack assemblies within datacenters. In particular, a hybrid cooling arrangement to service forced air, liquid block cooling of rack assemblies, and immersion cooling rack assemblies is presented.

### BACKGROUND

Datacenters house many rack-mounted electronic computing equipment, such as servers, processors, etc. In use, electronic processing assemblies generate a significant amount of heat that must be quelled or at least dissipated in order avoid electronic component failures and ensure continued efficient operation. Document WO2022/162174A1 discloses a rack assembly using both IC and rack cooling, wherein the respective cooling arrangements are thermally coupled to each other.

Various measures have been implemented to address the dissipation of heat generated by the electronic assemblies. A first being an autonomous rack configuration which implements forced-air ventilation and direct liquid block cooling techniques for cooling one or more heat-generating processing assemblies. The autonomous rack configuration includes a first cooling loop and a second cooling loop which are thermally connected by a liquid-to-liquid heat exchanger. Specifically, the first cooling loop contains a first heat transfer liquid conveyed to a plurality of liquid cooling blocks which are arranged in direct thermal contact with heat generating electronic processing assemblies. The first heat transfer liquid collects thermal energy from the electronic processing assemblies and is directed to a first side of the liquid-to-liquid heat exchanger. The second cooling loop contains a second heat transfer liquid which is directed to an air-to-liquid heat exchanger. The air-to-liquid heat exchanger transfers the thermal energy from the ambient air to the second heat transfer liquid which is then directed to the liquid-to-liquid heat exchanger. Within the liquid-to-liquid heat exchanger, thermal energy is transferred from the first heat transfer liquid to the second heat transfer liquid. In other words, there is a transfer of heat from the first cooling loop, which has a higher temperature, to the second cooling loop.

A second measure implemented to address the heat generated by the electronic processing assemblies involves immersive cooling (IC) racks. An IC rack includes an immersion case containing a dielectric immersion cooling fluid in which one or more electronic processing assemblies and a serpentine convection coil are submerged. A cooling fluid is directed through the serpentine convention coil to reduce the ambient temperature of the dielectric cooling fluid within the immersion casing. The cooling fluid is then directed towards the electronic processing assemblies. Similar to the autonomous rack, IC racks implements liquid cooling blocks in direct thermal contact with the electronic processing assemblies such that thermal energy is transferred from the electronic processing assemblies to the cooling fluid to reduce the temperature of the electronic processing assemblies. The now warm cooling fluid is then directed through an outlet.

There is thus an interest in developing a hybrid cooling arrangement.

### SUMMARY

The embodiments of the present disclosure are based on developers' understanding of the drawbacks associated with conventional autonomous rack and immersive cooling systems for cooling electronic assemblies containing heat-generating components. The present disclosure provides a hybrid cooling arrangement in which an autonomous rack configuration and IC rack configuration are thermally connected while remaining fluidly isolated, thus providing efficient heat dissipation of the electronic processing assemblies of each system.

According to one aspect of the present technology, there is provided a rack assembly including a cooling module for liquid-to-liquid cooling, a rack and an immersion cooling (IC) rack. The rack includes a rack cooling block configured to cool a rack electronic processing assembly when the rack electronic processing assembly is placed in contact with the rack cooling block and a rack fluid conduit configured to circulate a first cooling fluid through the rack cooling block and the cooling module. The immersion cooling (IC) rack includes a dielectric immersion cooling fluid, an IC cooling block immersed in the dielectric immersion cooling fluid and configured to cool an IC electronic processing assembly when the IC electronic processing assembly is placed in contact with the IC cooling block and an IC fluid conduit for circulating a second cooling fluid through the IC cooling block and the cooling module. The rack and the immersion cooling rack are thermally connected via the cooling module such that thermal energy can be transferred between the IC fluid conduit and the rack fluid conduit within the cooling module.

In some embodiments of the present technology, the IC rack further includes a plurality of immersion casings fluidly connected in parallel with one another and configured to house the dielectric immersion cooling fluid. The IC cooling block includes a plurality of IC cooling blocks. Each of the plurality of IC cooling blocks are housed within each of the plurality of immersion casings.

In some embodiments of the present technology, the IC rack further includes a plurality of IC racks immersion casings fluidly connected in series with one another and configured to house the dielectric immersion cooling fluid. The IC cooling block includes a plurality of IC cooling blocks. Each of the plurality of IC cooling blocks are housed within each of the plurality of immersion casings.

In some embodiments of the present technology, the rack further includes an air-to-liquid heat exchanger configured to receive the first cooling fluid via the rack fluid conduit such that thermal energy of the first cooling fluid is transferred to ambient air.

In some embodiments of the present technology, the air-to-liquid heat exchanger includes three air-to-liquid heat exchangers fluidly connected in series to one another, or three air-to-liquid heat exchangers fluidly connected in parallel to one another.

In some embodiments of the present technology, a temperature of the first cooling fluid prior to flowing through the air-to-liquid heat exchanger is 27°C.

In some embodiments of the present technology, a temperature of the first cooling fluid after exiting the air-to-liquid heat exchanger is greater than 30°C

In some embodiments of the present technology, the temperature of the first cooling fluid after exiting the air-to-liquid heat exchanger is 35°C.

In some embodiments of the present technology, the cooling module includes a cooling module pump and a liquid-to-liquid heat exchanger, wherein the cooling module pump is fluidly connected in series to the liquid-to-liquid heat exchanger.

In some embodiments of the present technology, the rack cooling block is fluidly connected downstream from the cooling module, or wherein the rack cooling block is fluidly connected upstream from the cooling module.

In some embodiments of the present technology, the rack fluid conduit and the IC fluid conduit are fluidly isolated from one another.

In some embodiments of the present technology, thermal energy is transferred from the IC fluid conduit to the rack fluid conduit within the cooling module.

In some embodiments of the present technology, the cooling module includes two cooling modules fluidly connected in parallel to one another.

In some embodiments of the present technology, the rack includes a plurality of racks fluidly connected in parallel with one another.

In some embodiments of the present technology, the rack includes a plurality of racks fluidly connected in series with one another.

In some embodiments of the present technology, the rack is assembled with the cooling module.

In some embodiments of the present technology, the rack further includes the rack electronic processing assembly, and wherein the IC rack further comprises the IC electronic processing assembly.

In some embodiments of the present technology, the at least one immersion casing includes a serpentine coil submerged in the dielectric fluid and fluidly connected to the second fluid conduit.

In some embodiments of the present technology, the rack fluid circuit includes an inlet and an outlet and wherein a temperature difference of the first cooling fluid between the inlet and the outlet is greater than 20°C.

In some embodiments of the present technology, the temperature difference of the first cooling fluid between the inlet and the outlet is 35°C.

In some embodiments of the present technology, a temperature of the first cooling fluid upstream from the cooling module is higher than a temperature of the first cooling fluid downstream from the cooling module.

In some embodiments of the present technology, a temperature of the second cooling fluid upstream from the cooling module is lower than a temperature of the second cooling fluid downstream from the cooling module.

In some embodiments of the present technology, a temperature of the first cooling fluid after exiting the cooling module is 47°C.

In some embodiments of the present technology, a temperature of the second cooling fluid prior to entering the cooling module is 43°C.

In some embodiments of the present technology, a temperature of the second cooling fluid after exiting the cooling module is 55°C.

In some embodiments of the present technology, a temperature of the first cooling fluid after exiting the rack electronic processing assembly is 62°C.

In some embodiments of the present technology, the rack assembly further includes at least one rack solenoid valve positioned on the rack fluid conduit.

In some embodiments of the present technology, the rack assembly further includes at least one IC rack solenoid valve positioned on the IC fluid conduit.

In some embodiments of the present technology, the IC rack further includes a cooling device.

In some embodiments of the present technology, the rack further comprises a plurality of racks, each rack comprising a distinct rack cooling block and a distinct air-to-liquid heat exchanger and wherein the distinct rack cooling blocks are connected in series with one another and the distinct air-to-liquid heat exchangers are connected in series with one another.

In some embodiments of the present technology, the rack further includes a plurality of racks, each rack comprising a distinct rack cooling block and a distinct air-to-liquid heat exchanger and wherein the distinct rack cooling blocks are connected in parallel with one another and the distinct air-to-liquid heat exchangers are connected in parallel with one another.

In the context of the present specification, unless expressly provided otherwise, electronic equipment may refer, but is not limited to, "servers", "electronic devices", "operation systems", "systems", "computer-based systems", "controller units", "monitoring devices", "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

It must be noted that, as used in this specification and the appended claims, the singular form "a", "an" and "the" include plural referents unless the context clearly dictates otherwise.

As used herein, the term "about" in the context of a given value or range refers to a value or range that is within 20%, preferably within 10%, and more preferably within 5% of the given value or range.

As used herein, the term "and/or" is to be taken as specific disclosure of each of the two specified features or components with or without the other. For example "A and/or B" is to be taken as specific disclosure of each of (i) A, (ii) B and (iii) A and B, just as if each is set out individually herein.

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of embodiments of the present technology will become apparent from the following description, the accompanying drawings, and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 illustrates a functional block diagram of a hybrid cooling arrangement servicing autonomous rack and immersion cooling rack configurations within a rack assembly, in accordance with the embodiments of the present disclosure;
Figure 2 illustrates a functional block diagram of an alternative hybrid cooling arrangement servicing autonomous rack and immersion cooling rack configurations within a rack assembly, in accordance with the embodiments of the present disclosure;
Figure 3 illustrates a functional block diagram of another alternative hybrid cooling arrangement servicing autonomous rack and immersion cooling rack configurations within a rack assembly, in accordance with the embodiments of the present disclosure; and,
Figure 4 illustrates a functional block diagram of yet another alternative hybrid cooling arrangement servicing autonomous rack and immersion cooling rack configurations within a rack assembly, in accordance with the embodiments of the present disclosure.

It should be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remain within the scope of the present technology. Further, where not examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

Aspects of the inventive concepts provided by the embodiments of the present disclosure are directed to a hybrid cooling arrangement capable of supporting the cooling needs of combined forced air and liquid block cooling configurations with immersive cooling configurations that coexist in datacenter rack assemblies.

Although the configurations of an autonomous cooling rack and an IC rack differ, there are certain features and different temperature tolerances which can be exploited to provide a hybrid cooling arrangement which can efficiently support both configurations within a datacenter rack assembly.

Furthermore, the developers have empirically observed that the internally channeled cooling liquid of the IC rack configurations are less temperature sensitive due to the use of dielectric immersion cooling fluids. As such, the IC rack configurations are capable of tolerating, and operating with, higher temperature channeled cooling liquids.

With these fundamental principles in place, we will now consider some non-limiting examples to illustrate various implementations of aspects of the present disclosure.

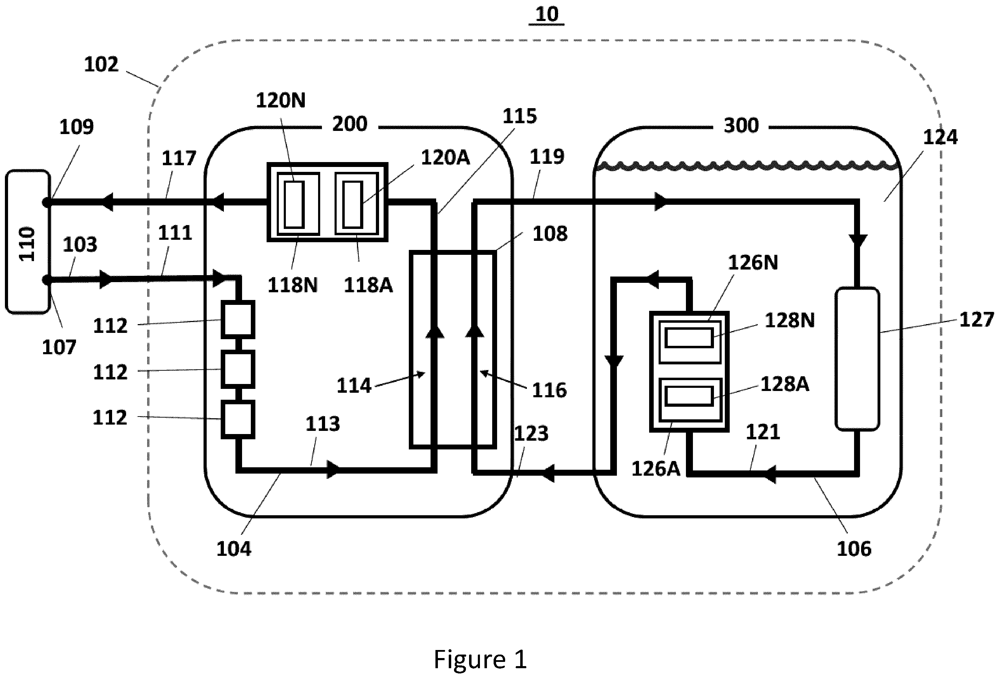

With reference to **Fig. 1****,** a functional block diagram of a hybrid cooling arrangement **10** is depicted. The hybrid cooling arrangement **10** is configured to service representative autonomous racks **200** and immersion cooling (IC) racks **300** within a datacenter rack assembly **102,** with the autonomous rack **200** and IC rack **300** configurations being fluidly isolated from one another. In other words, the autonomous rack **200** includes a rack fluid conduit **103** forming a first cooling circuit **104** and the IC rack **300** includes an IC fluid conduit **105** forming a second cooling circuit **106.** The first cooling circuit **104** and second cooling circuit **106** are not fluidly connected to one another. The hybrid cooling arrangement **10** is configured such that the first cooling circuit **104** and second cooling circuit **106** are thermally connected via at least one cooling module **108** for liquid-to-liquid cooling such that thermal energy can be transferred between the rack fluid conduit **103** of the first cooling circuit **104** of the autonomous rack **200** and the IC fluid conduit **105** of the second cooling circuit **106** of the IC rack **300.**

The autonomous rack **200** serviced by the hybrid cooling arrangement **10,** receives a rack cooling fluid from a liquid cooling source **110.** The rack cooling fluid may be a dielectric liquid or a non-dielectric liquid, for example and without limitation, water, glycol, oil, or a combination thereof. A cool rack cooling fluid **111** is supplied to the rack fluid conduit **103** via an inlet **107.** The cool rack cooling fluid **111** is circulated through the rack fluid conduit **103** and is returned to the liquid cooling source **110** via an outlet **109,** forming the first cooling circuit **104.** In this embodiment, the liquid cooling source **110** is a facility or the datacenter and the cool rack cooling fluid **111** is water.

The autonomous rack **200** includes at least one air-to-liquid heat exchanger **112.** In some embodiments, the at least one air-to-liquid heat exchanger **112** is equipped with a forced air ventilation fan. The at least one air-to-liquid heat exchanger **112** may include a rear door heat exchanger having a plate of multiple fans and a finned heat exchanger. For example, the fan plate and finned heat exchanger may be mounted on distinct hinges to allow for the opening of the finned heat exchanger while still enabling the fans to pull air. Alternatively, the fan plate may be mounted on hinges while the finned heat exchanger can be positioned on ergots.

The at least one air-to-liquid heat exchanger **112** includes internal fluid conduits (not shown) configured to receive the cool rack cooling fluid **111** and circulate the cool rack cooling fluid **111** throughout the at least one air-to-liquid heat exchanger **112.** Ambient air is pulled into the at least one air-to-liquid heat exchanger **112** and the thermal energy of the ambient air is transferred to the cool rack cooling fluid **111,** resulting in cool air being expelled. Due to the transfer of thermal energy to the cool rack cooling fluid **111,** the cool rack cooling fluid **111** increases in temperature and may be referred to, in its increased temperature state, as "warm rack cooling fluid **113".**

In this embodiment, the at least one air-to-liquid heat exchanger **112** comprises three air-to-liquid heat exchangers **112** which are fluidly connected in series with one another.

The warm rack cooling fluid **113** is directed from the at least one air-to-liquid heat exchanger **112** to the at least one cooling module **108** for liquid-to-liquid cooling. The at least one cooling module **108** thermally connects the autonomous rack **200** with the IC rack **300** such that thermally energy is transferred between the rack fluid conduit **103** of the first cooling circuit **104** and the IC fluid conduit **105** of the second cooling circuit **106.** In other words, thermal energy is transferred between the rack cooling fluid and an IC rack cooling fluid. More specifically, the warm rack cooling fluid **113** flows through a first side **114** while the IC rack cooling fluid flows through a second side **116** of the at least one cooling module **108.** Each of the first side **114** and the second side **116** of the at least one cooling module **108** include internal conduits (not shown) configured to receive the respective fluids of the autonomous rack **200** and IC rack **300.** In certain embodiments, the temperature of the IC rack cooling fluid is higher than that of the warm rack cooling fluid **113,** as such, thermal energy of the IC rack cooling fluid is transferred to the warm rack cooling fluid **113** within the at least one cooling module **108,** cooling the IC rack cooling fluid. The transfer of thermal energy to the warm rack cooling fluid **113** raises the temperature of the warm rack cooling fluid **113** which may further be referred to as "warmer rack cooling fluid **115".**

As depicted in **Fig. 1****,** in this embodiment, the at least one cooling module **108** is assembled with the autonomous rack **200.** The at least one cooling module **108** includes at least one pump and at least one plate heat exchanger, such that the at least one pump is fluidly connected in series with the at least one plate heat exchanger. In one embodiment, the at least one cooling module **108** includes two cooling modules fluidly connected in parallel with one another. In a specific example, the two cooling modules may be mini water-cooling modules.

The warmer rack cooling fluid **115** is directed from the at least one cooling module **108** and forwarded to one or more liquid cooling blocks **118A-118N.** The one or more liquid cooling blocks **118A-118N** are in direct thermal contact with corresponding electronic processing assemblies **120A-120N.** Each of the one or more liquid cooling blocks **118A-118N** include an internal fluid conduit (not shown) for directing the warmer rack cooling fluid **115** through the one or more liquid cooling blocks **118A-118N.** It is contemplated that there may be a plurality of the one or more liquid cooling blocks **118A-118N** and one or more electronic processing assemblies **120A-120N** arrangements which may be fluidly connected in series or, fluidly connected in parallel, or a combination thereof (not shown).

The warmer rack cooling fluid **115** flows through the one or more liquid cooling blocks **118A-118N,** in which thermal energy is transferred from the one or more electronic processing assemblies **120A-120N** to the warmer rack cooling fluid **115,** thus cooling the one or more electronic processing assemblies **120A-120N.** As a result, the temperature of the warmer rack cooling fluid **115** is raised which may further be referred to as "warmest rack cooling fluid **117".**

The warmest rack cooling fluid **117** is directed from the arrangement of the one or more liquid cooling blocks **118A-118N** and one or more electronic processing assemblies **120A-120N** and returned to the liquid cooling source **110** via the outlet **109.**

Exemplary temperatures along the fluid flow path of the autonomous rack **200** will now be presented. In certain embodiments, the cool rack cooling fluid from the liquid cooling source **110** may enter the rack fluid conduit **103** of the autonomous rack **200** between a temperature range of 25°C to 30°C, for example 27°C. The cool rack cooling fluid **111** is directed through the at least one air-to-liquid heat exchanger **112** in which thermal energy is transferred to the cool rack cooling fluid **111,** raising the temperature to a temperature between 33°C and 38°C, for example to 35°C. The warm rack cooling fluid **113** is forwarded into the at least one cooling module **108** in which thermal energy is transferred from the higher temperature IC cooling fluid to the warm rack cooling fluid **113,** raising the temperature to a temperature between 40°C and 45°C, for example 42°C. The warmer rack cooling fluid **115** is directed through the one or more liquid cooling blocks **118A-118N** and corresponding one or more electronic processing assemblies **120A-120N,** in which thermal energy is transferred to the warmer rack cooling fluid **115,** further raising the temperature to a temperature between 60°C and 65°C, for example to 62°C, completing the first fluid circuit **104** where the warmest rack cooling fluid **117** is returned to the liquid source **110** via the outlet **109.** Thus, the autonomous rack **200** configuration results in an ideal delta temperature, for example a temperature of 35°C, between the inlet **107** and the outlet **109** of the first fluid circuit **104.** In some embodiments, the warmest rack cooling fluid **117** may be conducted in areas where heating is beneficial (e.g. offices) such that thermal energy is used for heating purposes. Additionally, cooling the fluid from 62°C to 27°C, for example, is easier than cooling the fluid from 30°C to 25°C. Indeed, it has been measured that an air flow on a heat exchanger, as well as a rotation speed of a pump for conducting the rack cooling fluid, may be divided by 2 or even 3 times between these two illustrative situations. This allows for a generic cooling system to be used which reduces capital expenditure costs, and requires less power consumption and water consumption, reducing operating expenses.

The IC rack **300,** serviced by the hybrid cooling rack **10,** is arranged in a closed loop configuration in which the IC rack cooling fluid **119** is circulated through the IC fluid conduit **105,** forming the second cooling circuit **106.** The closed loop configuration provides the benefit of maintaining the high quality of the IC rack cooling fluid **119.** The IC rack cooling fluid **119** may be a dielectric liquid or a non-dielectric liquid, for example and without limitation, water, glycol, oil, or a combination thereof. In this embodiment, the IC cooling fluid is water.

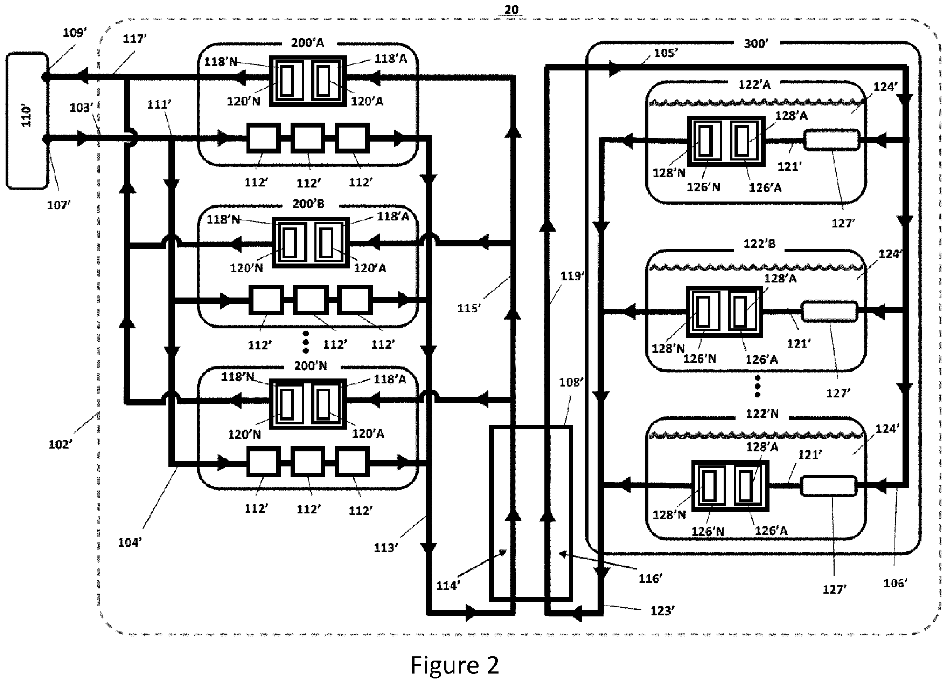

The IC rack **300** includes one or more liquid cooling blocks **126A-126N** which are in direct thermal contact with corresponding electronic processing assemblies **128A-128N.** The arrangement of the one or more liquid cooling blocks **126A-126N** and one or more electronic processing assemblies **128A-128N** are submerged in the dielectric immersion cooling fluid of the immersion casing **122.** Each of the one or more liquid cooling blocks **126A-126N** include an internal fluid conduit (not shown) for directing the IC rack cooling fluid **119** through the one or more liquid cooling blocks **126A-126N.** In certain embodiments, the IC rack **300** includes a plurality of the one or more liquid cooling blocks **126A-126N** and the one or more electronic processing assemblies **128A-128N** arrangements positioned within a single immersion bath housing the immersion fluid **124** (not shown). The plurality of the one or more liquid cooling blocks **126A-126N** and the one or more electronic processing assemblies **128A-128N** arrangements may be fluidly connected in series, or fluidly connected in parallel, or a combination thereof. In an alternative embodiment, the IC rack **300** includes a plurality of immersion casings where each of the immersion casings houses an arrangement of the one or more liquid cooling blocks **126A-126N** and the one or more electronic processing assemblies **128A-128N** submerged in the immersion fluid **124** (for example, seen in **Fig. 2**).

The IC rack **300** may further includes a cooling device **127** positioned upstream from the one or more liquid cooling blocks **126A-126N** and the one or more electronic processing assemblies **128A-128N** arrangement. The cooling device **127** is submerged within the immersion fluid **124** such that thermal energy is transferred from the immersion fluid **124** to the IC rack cooling fluid **119.** In certain embodiments, the cooling device **127** is a finned heat exchanger submerged in the immersion fluid **124.** In some alternative embodiments, the cooling device is 127 is a serpentine convection coil The IC rack cooling fluid **119** flows through the cooling device **127** and thermal energy is transferred from the immersion fluid **124** to the IC rack cooling fluid **119,** lowering the temperature of the immersion fluid **124.** As a result, the temperature of the IC rack cooling fluid **119** is raised and may now be referred to as "warm IC rack cooling fluid **121".**

The warm IC cooling fluid **121** flows through the one or more liquid cooling blocks **126A-126N,** in which thermal energy is transferred from the one or more electronic processing assemblies **120A-120N.** As a result, the temperature of the warm IC rack cooling fluid **121** is raised and may now be referred to as "warmer IC rack cooling fluid **123".**

The warmer IC rack cooling fluid **123** is directed from the arrangement of the one or more liquid cooling blocks **126A-126N** and the one or more electronic processing assemblies **128A-128N** to the at least one cooling module **108,** assembled with the autonomous rack **200** and configured to transfer thermal energy between the rack fluid conduit **103** of the first cooling circuit **104** and the IC fluid conduit **105** of the second cooling circuit **106.** As previously described, the warm IC rack cooling fluid **121** flows through the second side **116** of the at least one cooling module **108** via an internal conduit (not shown). In this embodiment, the warmer IC cooling fluid **123** has a higher temperature than the warm rack cooling fluid **113.** As such, thermal energy is transferred from the warmer IC cooling fluid **123** to the (cooler) warm rack cooling fluid **113,** raising the temperature of the warm rack cooling fluid **113.** The transfer of thermal energy from the warmer IC cooling fluid **123** cools the warmer IC cooling fluid **123** which may further be referred to as "IC cooling fluid **119".**

Exemplary temperatures along the fluid flow path of the IC rack **300** will now be presented. The IC rack cooling fluid **119** flows through the cooling device **127** between a temperature range of 43°C to 48°C, for example 43°C. Thermal energy is transferred from the immersion fluid **124** to the IC rack cooling fluid **119,** raising the temperature to a temperature between 63°C to 68°C, for example 63°C. The warm IC rack cooling fluid **121** flows through the one or more liquid cooling blocks **126A-126N** and the one or more electronic processing assemblies **128A-128N,** raising the temperature to a temperature between 43°C to 48°C, for example 43°C. Thermal energy is transferred to the warm IC rack cooling fluid **121,** raising the temperature to a temperature between 50°C to 60°C, for example to 55°C. The warmer IC rack cooling fluid **123** is directed through the at least one cooling module **108** where thermal energy is transferred from the warmer IC rack cooling fluid **123** to the warm rack cooling fluid **113,** cooling the warmer IC rack cooling fluid **121** to a temperature between 43°C and 48°C, for example to 43°C, which is then recirculated through the second fluid circuit **106.** These exemplary temperatures and temperature ranges provide better cooling efficiency and heat recovery without overheating the equipment.

It is to be noted that the fluid conduits **103, 105** which make up the first fluid circuit **104** of the autonomous rack **200** and the second fluid circuit **106** of the IC rack **300** may embody any suitable piping, tubing, conduit, or other sealed conveyance structures capable of effectively transferring and distributing fluids and may also consist of metal, rubber, or plastic materials or any combination thereof.

As discussed above regarding the autonomous rack **200,** the liquid cooling source **106** provides cool rack cooling fluid to the autonomous rack **200** configuration. In an alternative embodiment, the liquid cooling source **106** may correspond to an output of a heat exchanger, such as a dry cooler, which is configured to receive the warmest rack cooling fluid **117** and expel thermal energy thereof to provide the cool rack cooling fluid **111.**

Furthermore, as previously described, the at least one air-to-liquid heat exchanger **112** may comprise a plurality of air-to-liquid heat exchangers **112** fluidly connected in series. It is contemplated, in an alternative embodiment, that the plurality of air-to-liquid heat exchangers **112** may be fluidly connected in parallel with one another. In a further alternative embodiment, some of the plurality of air-to-liquid heat exchangers **112** may be connected in series while some of the plurality of air-to-liquid heat exchangers **112** may be connected in parallel.

It is further contemplated that the air-to-liquid heat exchanger **112** may be positioned with respect to the one or more liquid cooling blocks **118A-118N** and one or more electronic processing assemblies **120A-120N** arrangement. In some embodiments, the air-to-liquid heat exchanger **112** may be fluidly connected in series with the one or more liquid cooling blocks **118A-118N** and one or more electronic processing assemblies **120A-120N** arrangement. In an alternative embodiment, the air-to-liquid heat exchanger **112** may be fluidly connected in parallel with the one or more liquid cooling blocks **118A-118N** and one or more electronic processing assemblies **120A-120N** arrangement.

It is contemplated, in another alternative embodiment, that the at least one cooling module **108** may be assembled with the IC rack **300** instead of the autonomous rack **200.** It is further contemplated that the at least one cooling module **108** may be arranged separate from the autonomous rack 200 and the IC rack **300.**

It is further noted that the at least one cooling module **108** of the exemplary autonomous rack **200** configuration may include two pumps and two plate heat exchangers, where one pump is fluidly connected in series with one of the plate heat exchangers. It is appreciated that a benefit of utilizing at least one cooling module **108** with at least one pump provides a distribution of pressure drop effect between the liquid source **110** and the at least one cooling module **108.** Specifically, water pressure requirements are split between the pump of the liquid source **110** and the pump of the at least one cooling module **108** within the autonomous rack **200.** The use of multiple pumps, instead of a single pump, within the datacenter enables a smaller carbon emission footprint, reducing the capital expenditure costs, and enables easier control of fluid flow within the datacenter, reducing operating expenses.

In a further alternative embodiment, the at least one cooling module **108** may solely comprise at least one plate heat exchanger.

As discussed above, the one or more liquid cooling blocks **118A-118N** and one or more electronic processing assemblies **120A-120N** are positioned downstream from the at least one cooling module **108.** However, it is contemplated, in an alternative embodiment, that the one or more liquid cooling blocks **118A-118N** and one or more electronic processing assemblies **120A-120N** may instead be positioned upstream from the at least one cooling module **108.** In this embodiment, the warm rack cooling fluid **113** is forwarded from the at least one air-to-liquid heat exchanger **112** to the one or more liquid cooling blocks **118A-118N** and one or more electronic processing assemblies **120A-120N** arrangement. Thermal energy is transferred from the one or more electronic processing assemblies **120A-120N** to the warm rack cooling fluid **113,** raising the temperature of the warm rack cooling fluid **113** which may be referred to as "warmer rack cooling fluid **115".** The warmer rack cooling fluid **115** is then directed through the first side **114** of the at least one cooling module **108.** As previously described, thermal energy is transferred from the higher temperature IC rack cooling fluid to warmer rack cooling fluid **115,** raising the temperature of the warmer rack cooling fluid **115** which may be referred to as "warmest rack cooling fluid **117".** The warmest rack cooling fluid **117** is then forwarded to the liquid cooling source **110** via the outlet **109.**

As previously described, with regard to the IC rack **300** configuration, the second fluid circuit **106** is a closed loop configuration in which the IC rack cooling fluid **119** is circulated. It should be appreciated that, in an alternative embodiment, a semi-open loop configuration may be utilized. More specifically, the IC rack **300** configuration may receive and discharge the IC rack cooling fluid **119** from a cool IC rack liquid source, for example a reservoir.

As previously mentioned, the cooling device **127** of the IC rack **300** may be a serpentine convection coil which is submerged in the immersion fluid **124** of the immersion casing **122.** More specifically, the serpentine convection coil may be positioned upstream from the one or more liquid cooling blocks **126A-126N** and one or more electronic processing assemblies **128A-128N** arrangement. The serpentine convection coil is structured with multiple hollow channel coils configured to receive and internally channel the IC rack cooling fluid. The IC rack cooling fluid enters the serpentine convection coil and thermal energy is transferred from the ambient immersion fluid **124,** reducing the temperature of the immersion fluid **124** and raising the temperature of the IC rack cooling fluid. It is further contemplated that the cooling device **127** comprises a combination of a serpentine convection coil and a finned heat exchanger. The serpentine convection coil and finned heat exchanger may be fluidly connected in series with one another or, in an alternative embodiment, may be fluidly connected in parallel. It is appreciated that the serpentine convection coil may be positioned either upstream or downstream from the finned heat exchanger.

In some embodiments, the hybrid cooling arrangement **10** may implement a liquid distribution infrastructure comprising a flow controller, flow distribution channel segments, temperature sensors, and flow control valves to service the liquid cooling needs of both the autonomous rack **200** and IC rack **300** configurations. In certain embodiments, flow control valves may comprise solenoid valves to refine control and provide load re-partition. For example, it is contemplated that a temperature sensor may be positioned along the second fluid circuit **106** upstream from the cooling module **108** such that the temperature of the IC rack cooling fluid is detected before entering the cooling module **108.** A solenoid valve may be positioned on the first cooling circuit **104,** before the cooling module **108,** to modulate the flow of the rack cooling fluid into the cooling module **108** in response to the detected temperature of the IC rack cooling fluid. Thus, controlling the cooling system of the autonomous rack **200** and the IC rack **300** to avoid overheating, optimize heat recovery, and maximize the delta temperature based on the load of each of the racks **200, 300.**

With reference now to **Fig. 2****,** a functional block diagram of an alternative hybrid cooling arrangement **20** is depicted. The hybrid cooling arrangement **20** differs from the hybrid cooling arrangement **10** of **Fig. 1** in that a plurality of autonomous racks **200'A-200'N** are provided, and a single IC rack **300'** with a plurality of immersion casings **122'A-122'N** are provided in a datacenter rack assembly **102'.** Each autonomous rack of the plurality of autonomous racks **200'A-200'N** may correspond to the autonomous rack **200** of **Fig. 1****.** The IC rack **300'** may correspond to the IC rack **300** of **Fig. 1****.** The datacenter rack assembly **102'** may correspond to the datacenter rack assembly **102** of **Fig. 1****.**

The hybrid cooling arrangement **20** services the plurality of autonomous racks **200'A-200'N** and the IC rack **300',** with each of the plurality autonomous racks **200'A-200'N** being fluidly isolated from each of the immersion casings **122'A-122'N** of the IC rack **300'.** In other words, as with **Fig. 1****,** the plurality of autonomous racks **200'A-200'N** include the rack fluid conduit **103',** forming the first cooling circuit **104'** and the IC rack **300'** includes an IC fluid conduit **105',** forming a second cooling circuit **106'.** The rack fluid conduit **103',** the first cooling circuit **104',** the IC fluid conduit **105',** and the second cooling circuit **106',** may correspond to the rack fluid conduit **103,** the first cooling circuit **104,** the IC fluid conduit **105,** and the second cooling circuit **106** of **Fig. 1****.** The first cooling circuit **104'** is not fluidly connected to the second cooling circuit **106'.** Rather, the plurality of autonomous racks **200'A-200'N** and the IC rack **300'** are thermally connected via a cooling module **108'** such that thermal energy can be transferred between the rack fluid conduit **103'** of the first cooling circuit **104'** of the plurality of autonomous racks **200'A-200'N** and the IC fluid conduit **105'** of the second cooling circuit **106'** of the IC rack **300'.** It is appreciated that the cooling module **108'** may correspond to the at least one cooling module **108** of **Fig. 1****.**

In this embodiment, the plurality of autonomous racks **200'A-200'N** are fluidly connected in parallel to one another and the rack fluid conduit **103'** is configured to receive a cool rack cooling fluid **111'** from a liquid source **110'** via an inlet **107'.** It is noted that the cool rack cooling fluid **111',** liquid source **110',** and the inlet **107'** may correspond to the cool rack cooling fluid **111,** the liquid source **110,** and the inlet **107** of **Fig. 1****.** As previously described, the liquid source **110'** may be a facility with the received cool rack cooling fluid **111'** being water. Each of the plurality of autonomous racks **200'A-200'N** include at least one air-to-liquid heat exchanger **112'.** It should be noted that the at least one air-to-liquid heat exchanger **112'** may be configured as any of the previously described embodiments including the at least one air-to-liquid heat exchanger **112** of **Fig. 1****.** The at least one heat exchanger **112'** receives the cool rack cooling fluid **111'** which flows through internal fluid conduits (not shown) of the at least one heat exchanger **112'.** Thermal energy of ambient air is transferred to the cool rack cooling fluid **111'** and cool air is expelled. The transfer of thermal energy to the cool rack cooling fluid **111'** raises the temperature of the cool rack cooling fluid which may be referred to as "warm rack cooling fluid**113'"**. It is noted that the warm rack cooling fluid **113'** may correspond to the warm rack cooling fluid **113** of **Fig. 1****.**

As previously described, the warm rack cooling fluid is forwarded to a first side **114'** of the cooling module **108'** which thermally connects the rack fluid conduit **103'** of the first cooling circuit **104'** with the IC fluid conduit **105'** of the second cooling circuit **106'** for the transfer of thermal energy therebetween. It is appreciated that the first side **114'** may correspond to the first side **114** of **Fig. 1****.** In certain embodiments, the thermal energy of the higher temperature IC rack cooling fluid is transferred to the warm rack cooling fluid **113'** within the cooling module **108',** cooling the IC rack cooling fluid. The transfer of thermal energy to the warm rack cooling fluid **113'** raises the temperature of the warm rack cooling fluid **113'** which may further be referred to as "warmer rack cooling fluid **115'**". The warmer rack cooling fluid **115'** may correspond with the warmer rack cooling fluid **115** of **Fig. 1****.**

In this embodiment, the cooling module **108'** is arranged separate from the plurality of autonomous racks **200'A-200'N** and the IC rack **300'.** However, it is contemplated that the cooling module **108'** may be assembled with any one of the plurality of autonomous racks **200'A-200'N** or with the IC rack **300'.**

The warmer rack cooling fluid **115'** is directed from the cooling module **108'** and forwarded to one or more liquid cooling blocks **118'A-118'N** which are in direct thermal contact with corresponding electronic processing assemblies **120'A-120'N.** It is contemplated that the arrangement of the one or more liquid cooling blocks **118'A-118'N** and the one or more electronic processing assemblies **120'A-120'N** may be configured as any of the previously described embodiments, including the one or more liquid cooling blocks **118A-118N** and one or more electronic processing assemblies **120A-120N** of **Fig. 1****.** Thermal energy is transferred from the one or more electronic processing assemblies **120'A-120'N** to the warmer rack cooling fluid **115',** raising the temperature of the warmer rack cooling fluid **115'** which may further be referred to as "warmest rack cooling fluid **117'".** It is contemplated that the warmest rack cooling fluid **117'** may correspond to the warmest rack cooling fluid **117** of **Fig. 1****.** The warmest rack cooling fluid **117'** is then forwarded to the liquid cooling source **110'** via an outlet **109'.** The outlet **109'** may be configured as the outlet **109** of **Fig. 1****.**

An exemplary flow path of the rack cooling fluid through first cooling circuit **104'** of the plurality of autonomous racks **200'A-200'N** will now be described. The rack cooling fluid enters the first fluid circuit **104'** through the inlet **107'.** The fluid flows through the rack fluid conduit **103'** of the plurality of autonomous racks **200'A-200'N.** In **Fig. 1****,** the autonomous racks **200'A-200'N** are fluidly connected in parallel, as such, the fluid splits and flows through each of the autonomous racks **200'A-200'N** in parallel. In each of the autonomous racks **200'A-200'N,** the fluid flows through at least one air-to-liquid heat exchanger **112'.** The fluid is then directed through the at least one cooling module **108'.** Upon exiting the at least one cooling module **108',** the fluid is, again, split such that it flows through each of the autonomous racks **200'A-200'N** in parallel. Specifically, the fluid is advanced through the one or more liquid cooling blocks **118'A-118'N** and the one or more electronic processing assemblies **120'A-120'N** arrangement, and eventually returns to the liquid source **110'** via the outlet **109'.**

Regarding the IC rack **300',** each of the plurality of immersion casings **122'A-122'N** are fluidly connected in parallel with one another in a closed loop configuration which circulates an IC rack cooling fluid **119'.** The IC rack cooling fluid **119'** may correspond to the IC rack cooling fluid **119** of **Fig.** 1 and may be a dielectric liquid or a non-dielectric liquid, for example and without limitation, water, glycol, oil, or a combination thereof. In this embodiment, the IC cooling fluid **119'** is water.

Each of the plurality of immersion casings **122'A-122'N** houses an immersion cooling fluid **124',** for example a dielectric immersion cooling fluid. The immersion cooling fluid **124'** may correspond to the immersion cooling fluid **124** of **Fig. 1****.** Each of the immersion casings **122'A-122'N** of the IC rack **300**'includes one or more liquid cooling blocks **126'A-126'N** which are in direct thermal contact with corresponding electronic processing assemblies **128'A-128'N.** The arrangement of the one or more liquid cooling blocks **126'A-126'N** and one or more electronic processing assemblies **128'A-128'N** are submerged in the dielectric immersion cooling fluid of the immersion casing **122'A-112'N.** It is appreciated there may be a plurality of the one or more liquid cooling blocks **126'A-126'N** and one or more electronic processing assemblies **128'A-128'N** arrangements in each of the immersion casings **122'A-122'N** and that the one or more liquid cooling blocks **126'A-126'N** and one or more electronic processing assemblies **128'A-128'N** may be configured in any of the previously described embodiments including the one or more liquid cooling blocks **126A-126N** and one or more processing assemblies **128A-128N** of **Fig. 1****.** Each of the immersion casings **122'A-122'N** further includes a cooling device **127'** submerged in the immersion fluid **124'** and positioned upstream from the arrangement of the one or more liquid cooling blocks **126'A-126'N** and one or more electronic processing assemblies **128'A-128'N.** The cooling device **127'** may correspond to the cooling device **127** of any of the previously described embodiments, including the cooling device **127** of **Fig. 1****.**

The IC rack cooling fluid **119'** flows through the cooling device **127'** and thermal energy is transferred from the immersion fluid **124'** to the IC rack cooling fluid **119',** lowering the temperature of the immersion fluid **124'.** As a result, the temperature of the IC rack cooling fluid **119'** is raised and may now be referred to as "warm IC rack cooling fluid **121'".** The warm IC rack cooling fluid **121'** may correspond to the warm IC rack cooling fluid **121** of **Fig. 1****.**

The warm IC rack cooling fluid **121'** flows through the one or more liquid cooling blocks **126'A-126'N,** in which thermal energy is transferred from the one or more electronic processing assemblies **120'A-120'N.** As a result, the temperature of the warm IC rack cooling fluid **121'** is raised and may now be referred to as "warmer IC rack cooling fluid **123'".** The warmer IC rack cooling fluid **123'** may correspond to the warmer IC cooling rack fluid **123** of **Fig. 1****.**

As previously described, the warmer IC rack cooling fluid **123'** is directed from the arrangement of the one or more liquid cooling blocks **126'A-126'N** and the one or more electronic processing assemblies **128'A-128'N** to the second side **116'** of the cooling module **108'.** It is noted that the second side **116'** of the cooling module **108'** may correspond to the second side **116** of the at least one cooling module **108** of **Fig. 1****.** Thermal energy is transferred from the warmer IC cooling fluid **123'** to the (cooler) warm rack cooling fluid **113',** raising the temperature of the warm rack cooling fluid **113'** (as previously described). The transfer of thermal energy from the warmer IC cooling fluid **123'** cools the warmer IC cooling fluid **123'** which may further be referred to as "IC cooling fluid **119'".**

An exemplary flow path of the IC rack cooling fluid will now be described. The rack cooling fluid is circulated in a closed loop configuration. The fluid flows through the rack fluid conduit **105'** of the IC rack **300'.** In **Fig. 2****,** the IC rack **300'** is configured to have the plurality of immersion casings **122'A-122'N** fluidly connected in parallel, as such, the fluid splits and flows through each of the immersion casings **122'A-122'N** in parallel. In each of the immersion casings **122'A-122'N,** the fluid flows through the cooling device **127'.** The fluid is then directed through the one or more liquid cooling blocks **118'A-118'N** and the one or more electronic processing assemblies **120'A-120'N** arrangement housed within each of the immersion casings **122'A-122'N.** The fluid is then advanced through the at least one cooling module **108'** and recirculated through the IC rack **300'** configuration.

It is contemplated that instead of a plurality of immersion casings **122'A-122'N,** the IC rack **300'** may include a plurality of one or more liquid cooling blocks **126'A-126'N** and the one or more electronic processing assemblies **120'A-120'N** arrangements housed within an immersion bath (not shown). In a further alternative embodiment, the IC rack **300'** may have a combination of immersion casings **122'A-122'N** and an immersion bath (not shown).

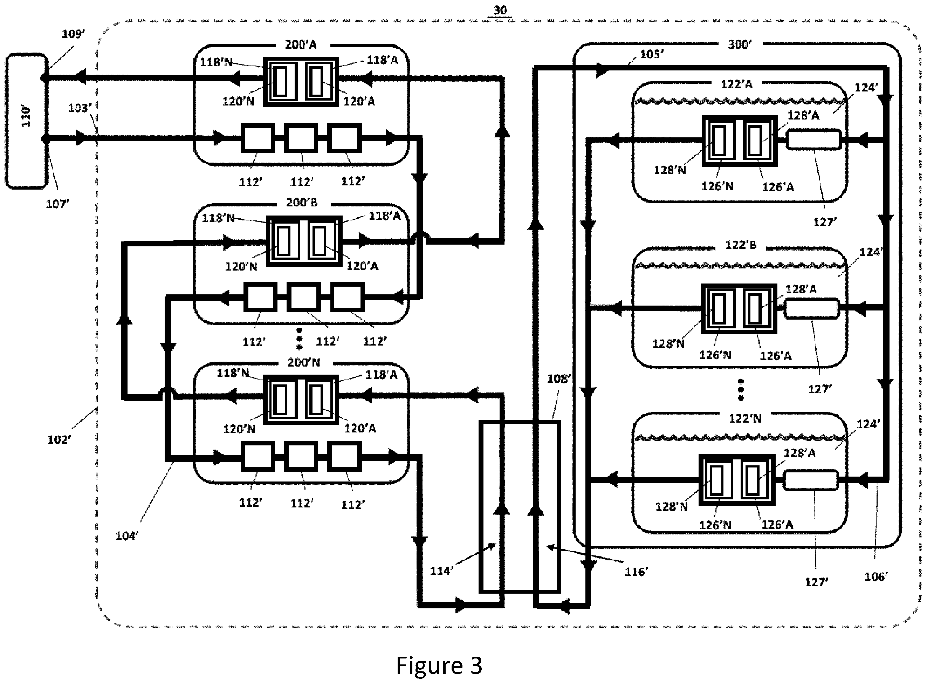

An alternative hybrid cooling arrangement **30** is depicted in **Fig. 3****.** It is appreciated that the plurality of autonomous racks **200'A-200'N** may be fluidly connected to one another in series with one another. It is further contemplated that some of the plurality of autonomous racks **200'A-200'N** may be fluidly connected in series and some of the plurality of autonomous racks **200A'-200'N** may be connected in parallel (not shown).

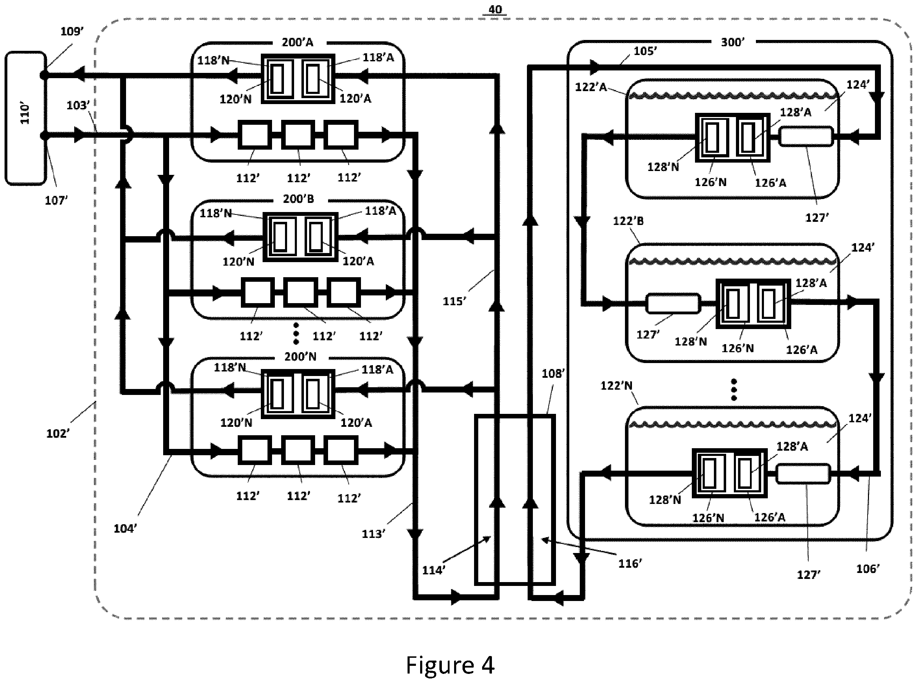

As previously described, the plurality of immersion casings **122'A-122'N** of the IC rack **300'** may be fluidly connected to one another in parallel. However, as depicted in **Fig. 4****,** the hybrid cooling arrangement **40** may include the immersion casings **122'A-122'N** being fluidly connected to one another in series. Alternatively, some of the plurality of immersion casings **122'A-122'N** may be fluidly connected in series and some of the plurality of immersion casings **122'A-122'N** may be fluidly connected in parallel (not shown).

It is contemplated, in an alternative embodiment, that the hybrid cooling arrangement (not shown) may include a single autonomous rack and a plurality of IC racks thermally connected via a cooling module, such as the cooling module **108** or the cooling module **108'.** It is noted that the autonomous rack, each of the plurality of IC racks, and the cooling module of this alternative embodiment may be configured as any of the autonomous rack, the IC racks, and the cooling module in the previously described embodiments.

As presented herein, the disclosed embodiments provide hybrid cooling arrangements **10, 20, 30, 40** that provide thermally integrative cooling infrastructure to accommodate the cooling needs of the autonomous rack **200, 200'A-200'N** and the IC rack **300, 300'** configurations coexisting within a datacenter rack assembly **102, 102'.** The hybrid cooling arrangement **10, 20, 30, 40** provides at least one cooling module **108, 108'** configured to thermally connect the autonomous rack **200, 200'A-200'N** and IC rack **300, 300',** thereby enabling the transfer of thermal energy between the two.

The disclosed embodiments of the hybrid cooling arrangement **10, 20, 30, 40** provide various benefits including, but not limited to, an increased delta temperature between an inlet **107, 107'** and outlet **109, 109'** of the first fluid circuit **104, 104'** within the autonomous rack **200, 200'A-200'N.** This increased in delta temperature has a significant impact on the reduction of datacenter operating expenses and capital expenditures. Additionally, the disclosed configuration of the autonomous rack **200, 200'A-200'N** allows for a distribution of pressure drop effect between the cooling liquid source **110, 110'** and the at least one cooling module **108, 108'.** The hybrid cooling arrangement **10, 20, 30, 40** requires less pumping and no sophisticated pumps, ultimately reducing costs. Furthermore, as the IC rack **300, 300'** configuration is fluidly isolated, the quality of the IC rack cooling fluid can be preserved.

In view of the various disclosures directed to a hybrid cooling arrangement for servicing both autonomous racks and IC racks deployed within a datacenter rack assembly, it will be understood that, although the embodiments presented herein have been described with reference to specific features and structures, it is clear that various modifications and combinations may be made without departing from such disclosures. The specification and drawings are, accordingly, to be regarded simply as an illustration of the discussed implementations or embodiments and their principles as defined by the appended claims, and are contemplated to cover any and all modifications, variations, combinations or equivalents that fall within the scope of the present claims.

## Claims

1. A rack assembly (10, 20, 30, 40) comprising:
a cooling module (108, 108') for liquid-to-liquid cooling;
a rack (200, 200'A-200'N) comprising:
a rack cooling block (118A-118N, 118'A-118'N) configured to cool a rack electronic processing assembly (120A-120N, 120'A-120'N) when the rack electronic processing assembly is placed in contact with the rack cooling block; and,
a rack fluid conduit (103, 103') configured to circulate a first cooling fluid through the rack cooling block and the cooling module;
and,
an immersion cooling (IC) rack (300, 300') comprising:
a dielectric immersion cooling fluid (124, 124');
an IC cooling block (126A-126N, 126'A-126'N) immersed in the dielectric immersion cooling fluid and configured to cool an IC electronic processing assembly (128A-128N, 128'A-128'N) when the IC electronic processing assembly is placed in contact with the IC cooling block; and,
an IC fluid conduit (105, 105') configured to circulate a second cooling fluid through the IC cooling block and the cooling module;
wherein the rack and the immersion cooling rack are thermally connected via the cooling module such that thermal energy can be transferred between the IC fluid conduit and the rack fluid conduit within the cooling module.

2. The rack assembly of claim 1, wherein the IC rack further comprises:
a plurality of immersion casings (122'A-122'N) fluidly connected in parallel with one another and configured to house the dielectric immersion cooling fluid;
wherein the IC cooling block comprises a plurality of IC cooling blocks; and,
each of the plurality of IC cooling blocks are housed within each of the plurality of immersion casings.

3. The rack assembly of claim 1, wherein the IC rack further comprises:
a plurality of IC racks immersion casings fluidly connected in series with one another and configured to house the dielectric immersion cooling fluid;
wherein the IC cooling block comprises a plurality of IC cooling blocks; and,
each of the plurality of IC cooling blocks are housed within each of the plurality of immersion casings.

4. The rack assembly of any one of claims 1 to 3, wherein the rack further comprises an air-to-liquid heat exchanger (112, 112') configured to receive the first cooling fluid via the rack fluid conduit such that thermal energy of the first cooling fluid is transferred to ambient air.

5. The rack assembly of any one of claims 1 to 4, wherein the cooling module comprises a cooling module pump and a liquid-to-liquid heat exchanger, wherein the cooling module pump is fluidly connected in series to the liquid-to-liquid heat exchanger.

6. The rack assembly of any one of claims 1 to 5, wherein the rack cooling block is fluidly connected downstream from the cooling module, or wherein the rack cooling block is fluidly connected upstream from the cooling module.

7. The rack assembly of any one of claims 1 to 6, wherein the rack fluid conduit and the IC fluid conduit are fluidly isolated from one another.

8. The rack assembly of any one of claims 1 to 7, wherein thermal energy is transferred from the IC fluid conduit to the rack fluid conduit within the cooling module.

9. The rack assembly of any one of claims 1 to 8, wherein the rack comprises a plurality of racks (200'A-200'N) fluidly connected in parallel with one another.

10. The rack assembly of any one of claims 1 to 9, wherein the rack comprises a plurality of racks fluidly connected in series with one another.

11. The rack assembly of any one of claims 1 to 10, wherein the rack further comprises the rack electronic processing assembly (120A-120N, 120'A-120'N), and wherein the IC rack further comprises the IC electronic processing assembly (128A-128N, 128'A-128'N).

12. The rack assembly of any one of claims 1 to 11, wherein the IC rack further comprises a cooling device (127, 127').

13. The rack assembly of any one of claims 1 to 12, wherein the rack fluid circuit comprises an inlet (107, 107') and an outlet (109,109') and wherein a temperature difference of the first cooling fluid between the inlet and the outlet is greater than 20°C.

14. The rack assembly of claim 1, wherein the rack further comprises a plurality of racks, each rack comprising a distinct rack cooling block (118A-118N, 118'A-118'N) and a distinct air-to-liquid heat exchanger (112, 112') and wherein the distinct rack cooling blocks (118A-118N, 118'A-118'N) are connected in series with one another and the distinct air-to-liquid heat exchangers (112, 112') are connected in series with one another.

15. The rack assembly of claim 1, wherein the rack further comprises a plurality of racks, each rack comprising a distinct rack cooling block (118A-118N, 118'A-118'N) and a distinct air-to-liquid heat exchanger (112, 112') and wherein the distinct rack cooling blocks (118A-118N, 118'A-118'N) are connected in parallel with one another and the distinct air-to-liquid heat exchangers (112, 112') are connected in parallel with one another.

## Patentansprüche

1. Rackbaugruppe (10, 20, 30, 40), umfassend:
ein Kühlmodul (108, 108') zur Flüssigkeit-zu-Flüssigkeit-Kühlung;
ein Rack (200, 200'A-200'N), umfassend:
einen Rack-Kühlblock (118A-118N, 118'A-118'N), der konfiguriert ist, um eine Rack-elektronische Verarbeitungsbaugruppe (120A-120N, 120'A-120'N) zu kühlen, wenn die Rack-elektronische Verarbeitungsbaugruppe in Kontakt mit dem Rack-Kühlblock gebracht wird; und,
eine Rack-Fluidleitung (103, 103'), die konfiguriert ist, ein erstes Kühlfluid durch den Rack-Kühlblock und das Kühlmodul zu zirkulieren;
und,
ein Tauchkühlungs-(IC-)Rack (300, 300'), umfassend:
ein dielektrisches Tauchkühlfluid (124, 124');
einen IC-Kühlblock (126A-126N, 126'A-126'N), der in das dielektrische Tauchkühlfluid eingetaucht ist und konfiguriert ist, eine IC-elektronische Verarbeitungseinheit (128A-128N, 128'A-128'N) zu kühlen, wenn die IC-elektronische Verarbeitungsbaugruppe in Kontakt mit dem IC-Kühlblock gebracht wird; und,
eine IC-Fluidleitung (105, 105'), die konfiguriert ist, ein zweites Kühlfluid durch den IC-Kühlblock und das Kühlmodul zu zirkulieren;
wobei das Rack und das Tauchkühlungs-Rack thermisch über das Kühlmodul verbunden sind, derart, dass Wärmeenergie zwischen der IC-Fluidleitung und der Rack-Fluidleitung innerhalb des Kühlmoduls übertragen werden kann.

2. Rackbaugruppe nach Anspruch 1, wobei das IC-Rack ferner umfasst:
eine Vielzahl von Tauchgehäusen (122'A-122'N), die fluidisch parallel miteinander verbunden sind und konfiguriert sind, um das dielektrische Tauchkühlfluid aufzunehmen;
wobei der IC-Kühlblock eine Vielzahl von IC-Kühlblöcken umfasst; und,
wobei jeder der Vielzahl von IC-Kühlblöcken in jeweils einem der Vielzahl von Tauchgehäusen untergebracht ist.

3. Rackbaugruppe nach Anspruch 1, wobei das IC-Rack ferner umfasst:
eine Vielzahl von IC-Rack-Tauchgehäusen, die fluidisch in Reihe miteinander verbunden sind und konfiguriert sind, um das dielektrische Tauchkühlfluid aufzunehmen;
wobei der IC-Kühlblock eine Vielzahl von IC-Kühlblöcken umfasst; und,
wobei jeder der Vielzahl von IC-Kühlblöcken in jeweils einem der Vielzahl von Tauchgehäusen untergebracht ist.

4. Rackbaugruppe nach einem der Patentansprüche 1 bis 3, wobei das Rack weiterhin einen Luft-zu-Flüssigkeit-Wärmetauscher (112, 112') umfasst, der konfiguriert ist, das erste Kühlfluid über die Rack-Fluidleitung aufzunehmen, derart, dass Wärmeenergie des ersten Kühlfluids an die Umgebungsluft übertragen wird.

5. Rackbaugruppe nach einem der Patentansprüche 1 bis 4, wobei das Kühlmodul eine Kühlmodulpumpe und einen Flüssigkeit-zu-Flüssigkeit-Wärmetauscher umfasst, wobei die Kühlmodulpumpe fluidisch in Reihe mit dem Flüssigkeit-zu-Flüssigkeit-Wärmetauscher verbunden ist.

6. Rackbaugruppe nach einem der Patentansprüche 1 bis 5, wobei der Rack-Kühlblock fluidisch stromabwärts vom Kühlmodul verbunden ist oder wobei der Rack-Kühlblock fluidisch stromaufwärts vom Kühlmodul verbunden ist.

7. Rackbaugruppe nach einem der Patentansprüche 1 bis 6, wobei die Rack-Fluidleitung und die IC-Fluidleitung fluidisch voneinander isoliert sind.

8. Rackbaugruppe nach einem der Patentansprüche 1 bis 7, wobei Wärmeenergie von der IC-Fluidleitung zur Rack-Fluidleitung innerhalb des Kühlmoduls übertragen wird.

9. Rackbaugruppe nach einem der Patentansprüche 1 bis 8, wobei das Rack eine Vielzahl von Racks (200'A-200'N) umfasst, die fluidisch parallel zueinander verbunden sind.

10. Rackbaugruppe nach einem der Patentansprüche 1 bis 9, wobei das Rack eine Vielzahl von Racks umfasst, die fluidisch in Reihe miteinander verbunden sind.

11. Rackbaugruppe nach einem der Patentansprüche 1 bis 10, wobei das Rack ferner die Rack-elektronische Verarbeitungsbaugruppe (120A-120N, 120'A-120'N) umfasst und wobei das IC-Rack ferner die IC-elektronische Verarbeitungsbaugruppe (128A-128N, 128'A-128'N) umfasst.

12. Rackbaugruppe nach einem der Patentansprüche 1 bis 11, wobei das IC-Rack ferner eine Kühlvorrichtung (127, 127') umfasst.

13. Rackbaugruppe nach einem der Patentansprüche 1 bis 12, wobei der Rack-Fluidkreislauf einen Einlass (107, 107') und einen Auslass (109, 109') umfasst und wobei eine Temperaturdifferenz des ersten Kühlfluids zwischen dem Einlass und dem Auslass größer als 20°C ist.

14. Rackbaugruppe nach Anspruch 1, wobei das Rack ferner eine Vielzahl von Racks umfasst, wobei jedes Rack einen separaten Rack-Kühlblock (118A-118N, 118'A-118'N) und einen separaten Luft-zu-Flüssigkeit-Wärmetauscher (112, 112') umfasst und wobei die separaten Rack-Kühlblöcke (118A-118N, 118'A-118'N) in Reihe miteinander verbunden sind und die separaten Luft-zu-Flüssigkeit-Wärmetauscher (112, 112') in Reihe miteinander verbunden sind.

15. Rackbaugruppe nach Anspruch 1, wobei das Rack ferner eine Vielzahl von Racks umfasst, wobei jedes Rack einen separaten Rack-Kühlblock (118A-118N, 118'A-118'N) und einen separaten Luft-zu-Flüssigkeit-Wärmetauscher (112, 112') umfasst und wobei die separaten Rack-Kühlblöcke (118A-118N, 118'A-118'N) parallel zueinander verbunden sind und die separaten Luft-zu-Flüssigkeit-Wärmetauscher (112, 112') parallel zueinander verbunden sind.

## Revendications

1. Ensemble grille (10, 20, 30, 40) comprenant :
un module de refroidissement (108, 108') pour le refroidissement liquide-liquide ;
une grille (200, 200'A-200'N) comprenant :
un bloc de refroidissement de grille (118A-118N, 118'A-118'N) conçu pour refroidir un ensemble de traitement électronique de grille (120A-120N, 120'A-120'N) lorsque l'ensemble de traitement électronique de grille est mis en contact avec le bloc de refroidissement de grille ; et,
un conduit de fluide de grille (103, 103') conçu pour faire circuler un premier fluide de refroidissement à travers le bloc de refroidissement de grille et le module de refroidissement ; et,
une grille de refroidissement par immersion (IC) (300, 300') comprenant :
un fluide de refroidissement par immersion diélectrique (124, 124') ;
un bloc de refroidissement IC (126A-126N, 126'A-126'N) immergé dans le fluide de refroidissement par immersion diélectrique et conçu pour refroidir un ensemble de traitement électronique IC (128A-128N, 128'A-128'N) lorsque l'ensemble de traitement électronique IC est mis en contact avec le bloc de refroidissement IC ; et,
un conduit de fluide IC (105, 105') conçu pour faire circuler un second fluide de refroidissement à travers le bloc de refroidissement IC et le module de refroidissement ;
dans lequel la grille et la grille de refroidissement par immersion sont thermiquement reliés par l'intermédiaire du module de refroidissement de sorte qu'une énergie thermique peut être transférée entre le conduit de fluide IC et le conduit de fluide de grille à l'intérieur du module de refroidissement.

2. Ensemble grille selon la revendication 1, dans lequel la grille IC comprend en outre :
une pluralité de boîtiers d'immersion (122'A-122'N) reliés fluidiquement en parallèle les uns avec les autres et conçus pour loger le fluide de refroidissement par immersion diélectrique ;
dans lequel le bloc de refroidissement IC comprend une pluralité de blocs de refroidissement IC ; et,
chacun de la pluralité de blocs de refroidissement IC est logé dans chacun de la pluralité de boîtiers d'immersion.

3. Ensemble grille selon la revendication 1, dans lequel la grille IC comprend en outre :
une pluralité de boîtiers d'immersion de grilles IC reliés fluidiquement en série les uns avec les autres et conçus pour loger le fluide de refroidissement par immersion diélectrique ;
dans lequel le bloc de refroidissement IC comprend une pluralité de blocs de refroidissement IC ; et,
chacun de la pluralité de blocs de refroidissement IC est logé dans chacun de la pluralité de boîtiers d'immersion.

4. Ensemble grille selon l'une quelconque des revendications 1 à 3, dans lequel la grille comprend en outre un échangeur de chaleur air-liquide (112, 112') conçu pour recevoir le premier fluide de refroidissement par l'intermédiaire du conduit de fluide de grille de sorte qu'une énergie thermique du premier fluide de refroidissement est transférée à de l'air ambiant.

5. Ensemble grille selon l'une quelconque des revendications 1 à 4, dans lequel le module de refroidissement comprend une pompe de module de refroidissement et un échangeur de chaleur liquide-liquide, dans lequel la pompe de module de refroidissement est reliée fluidiquement en série à l'échangeur de chaleur liquide-liquide.

6. Ensemble grille selon l'une quelconque des revendications 1 à 5, dans lequel le bloc de refroidissement de grille est relié fluidiquement en aval du module de refroidissement, ou dans lequel le bloc de refroidissement de grille est relié fluidiquement en amont du module de refroidissement.

7. Ensemble grille selon l'une quelconque des revendications 1 à 6, dans lequel le conduit de fluide de grille et le conduit de fluide IC sont fluidiquement isolés l'un de l'autre.

8. Ensemble grille selon l'une quelconque des revendications 1 à 7, dans lequel une énergie thermique est transférée du conduit de fluide IC au conduit de fluide de grille à l'intérieur du module de refroidissement.

9. Ensemble grille selon l'une quelconque des revendications 1 à 8, dans lequel la grille comprend une pluralité de grilles (200'A-200'N) reliées fluidiquement en parallèle les unes avec les autres.

10. Ensemble grille selon l'une quelconque des revendications 1 à 9, dans lequel la grille comprend une pluralité de grilles reliées fluidiquement en série les unes avec les autres.

11. Ensemble grille selon l'une quelconque des revendications 1 à 10, dans lequel la grille comprend en outre l'ensemble de traitement électronique de grille (120A-120N, 120'A-120'N), et dans lequel la grille IC comprend en outre l'ensemble de traitement électronique IC (128A-128N, 128'A-128'N).

12. Ensemble grille selon l'une quelconque des revendications 1 à 11, dans lequel la grille IC comprend en outre un dispositif de refroidissement (127, 127').

13. Ensemble grille selon l'une quelconque des revendications 1 à 12, dans lequel le circuit de fluide de grille comprend une entrée (107, 107') et une sortie (109, 109') et dans lequel une différence de température du premier fluide de refroidissement entre l'entrée et la sortie est supérieure à 20 °C.

14. Ensemble grille selon la revendication 1, dans lequel la grille comprend en outre une pluralité de grilles, chaque grille comprenant un bloc de refroidissement de grille (118A-118N, 118'A-118'N) distinct et un échangeur de chaleur air-liquide (112, 112') distinct et dans lequel les blocs de refroidissement de grille (118A-118N, 118'A-118'N) distincts sont reliés en série les uns avec les autres et les échangeurs de chaleur air-liquide (112, 112') distincts sont reliés en série les uns avec les autres.

15. Ensemble grille selon la revendication 1, dans lequel la grille comprend en outre une pluralité de grilles, chaque grille comprenant un bloc de refroidissement de grille (118A-118N, 118'A-118'N) distinct et un échangeur de chaleur air-liquide (112, 112') distinct et dans lequel les blocs de refroidissement de grille (118A-118N, 118'A-118'N) distincts sont reliés en parallèle les uns avec les autres et les échangeurs de chaleur air-liquide (112, 112') distincts sont reliés en parallèle les uns avec les autres.
